# EUROPEAN PATENT APPLICATION

(11) **EP 0 618 612 A2**
(43) Date of publication of application: **05.10.1994**
(21) Application number: 94104530.4
(22) Date of filing: 22.03.1994
(51) Int. Cl.: H01L 21/306, H01L 21/00, C23G 1/02

(54) **Method of cleaning semiconductor device and equipment for cleaning semiconductor device**

(30) Priority: 23.03.1993 JP 63701/93
(71) Applicant: MATSUSHITA ELECTRIC INDUSTRIAL CO., LTD., Kadoma-shi, Osaka-fu, 571 (JP)
(72) Inventor: Ohnishi, Teruhito, Hirakata-shi, Osaka 573 (JP); Yano, Kousaku, Katano-shi, Osaka 576 (JP); Nomura, Noboru, Kyoto-shi, Kyoto 612 (JP); Endo, Masayuki, Izumi-shi, Osaka 594 (JP)
(74) Representative: Grünecker, Kinkeldey, Stockmair & Schwanhäusser Anwaltssozietät

(57) **Abstract**

The present invention discloses a cleaning solution used to wash a semiconductor substrate surface. This cleaning solution contains these components: a liquid mixture of sulfuric acid and hydrogen peroxide to remove organic and inorganic residues; fluorosulfuric acid for generation of fluorine which serves as an etchant to remove other residues and particles; and water.

## Description

### FIELD OF THE INVENTION

The present invention generally relates to semiconductor device fabrication, and more particularly to a cleaning technique used to remove contaminants such as organic residues, inorganic residues, other residues, and particles from a surface of a semiconductor substrate.

### BACKGROUND OF THE INVENTION

The semiconductor wafer size has recently changed from 6 inches to 8 inches, and now to 12 inches, which results in increasing cleaning costs involved in cleaning semiconductor wafers having such a large diameter. Since semiconductor device dimensions have been reduced to submicron regions, the process of cleaning must be carried out, with no residues nor particles left on a semiconductor substrate surface.

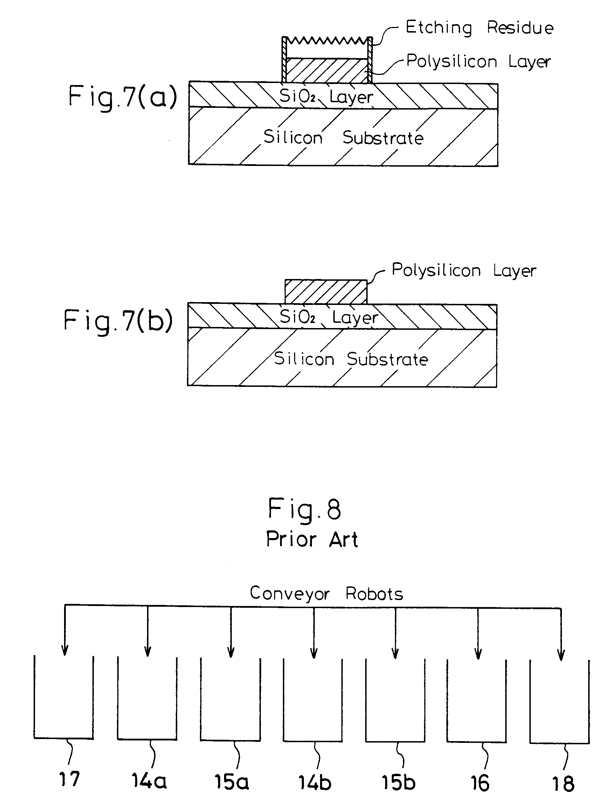

FIGURE 8 shows conventional semiconductor substrate cleaning equipment. In FIGURE 8, a first cleaning bath 14a and a second cleaning bath 14b are shown each of which may contain a heater depending on the cleaning solution type used. 15a is a first water-washing bath. 15b is a second water-washing bath. Nothing but deionized water is supplied to both the first water-washing bath 15a and the second water-washing bath 15b. The first cleaning bath 14a and the first water-washing bath 15a serve in pair. The second cleaning bath 14b and the second water-washing bath 15b serve in pair. Plural such pairs are arranged in the order in which they are used. 16 is a dry means such as a spin dryer. 17 is a loader. 18 is an unloader.

A cleaning technique based on the above-described semiconductor device cleaning equipment is explained.

The first cleaning bath 14a holds a first cleaning solution with a 5 : 1 ratio of sulfuric acid : hydrogen peroxide. The temperature of the first cleaning solution is about 130°C. On the other hand, the second cleaning bath 14b holds a second cleaning solution with a 1 : 1: 5 ratio of ammonium hydroxide: hydrogen peroxide : water. The temperature of the second cleaning solution is about 70 °C.

A semiconductor substrate carrier is carried into the first cleaning bath 14a. In the first cleaning bath 14a, a semiconductor substrates held by the carrier are washed for removal of contaminants (e.g., residual photoresists). Then, the carrier is moved into the first water-washing bath 15a for removal of the first cleaning solution.

Next, the carrier is carried into the second cleaning bath 14b where particles on the semiconductor substrate surface are removed. Thereafter, the carrier is moved into the second water-washing bath 15b for removal of the second cleaning solution. Then, the semiconductor substrates are subjected to a dry process by means of the dry means 16. The dried semiconductor substrates are delivered to the unloader 18. The above-described conveyance is done by conveyor robots having a chuck mechanism.

As described above, the conventional semiconductor device cleaning method involves four steps: a first cleaning step to remove organic and inorganic residues using the first cleaning solution; a first water-washing step; a second cleaning step to remove other residues including particles using the second cleaning solution; and a second water-washing step. This means that at least two pairs of cleaning baths and two pairs of water-washing baths are needed. More installation space is required. The decrease in throughput occurs.

Decomposition/removal of C-F system residues due to SiO₂ layer etching and Si-Br system residues due to silicon etching cannot be done by a cleaning solution of sulfuric acid and hydrogen peroxide. An appropriate solution capable of etching a semiconductor substrate surface must be used to remove such residues in a lift-off manner.

Japanese Patent Application, published under No. 4-234188, discloses a semiconductor substrate cleaning technique. In this cleaning technique, the removing of contaminants (i.e., organic residues, inorganic residues, residues after dry etching, and particles) is carried out within a single cleaning bath. This cleaning bath holds a cleaning solution of strong acid, an oxidant, and hydrofluoric acid.

The examination, made by the inventor, showed that the above-described cleaning technique produced the problem that such a cleaning solution had degraded after an elapse of a certain period of time. As a result, the cleaning state became unstable.

### SUMMARY OF THE INVENTION

It is an object of the present invention to provide an improved semiconductor device cleaning method which prevents a cleaning solution from degrading with time.

In accordance with the present invention, a fluorine-contained chemical compound of fluorosulfuric acid (HSO₃F) or SO₂F₂ is used instead of using hydrofluoric acid, which generates fluorine by hydrolysis when the fluorine of the cleaning solution decreases in amount.

More specifically, the present invention discloses a method of cleaning a semi conductor device wherein a cleaning solution is used to wash a surface of a semi conductor substrate. This cleaning solution has a composition of:
(a) a strong acid and an oxidant to remove organic and inorganic residues from the surface of the semiconductor substrate,
(b) a fluorine-contained chemical compound of HSO₃F or SO₂F₂ which generates fluorine to remove other residues and particles from the surface of the semiconductor substrate by slightly etching the surface of the semiconductor substrate, and
(c) water.

According to this cleaning method, organic and inorganic residues are removed by the strong acid and the oxidant, and etching residues and particles are lifted off from the surface by very slight etching by the fluorine ions generated by HSO₃F or SO₂F₂.

For the case of using HSO₃F as a fluorine-contained chemical compound, if the amount of ions of fluorine decreases due to vaporization, the reaction written as HSO₃F + H₂O →H₂SO₄ + HF takes place thereby generating hydrofluoric acid and ions of fluorine. If the fluorine ion concentration increases due to the vaporization of water of the cleaning solution, the reaction of HSO₃F + H₂O ← H₂SO₄ + HF takes place thereby decreasing the amount of ions of fluorine.

Therefore, the amount of ions of fluorine of the cleaning solution is kept at an approximately constant value. The etch rate becomes stable, compared with a cleaning solution that contains hydrofluoric acid. As a result, residues and particles can be removed in a stable manner.

If SO₂F₂ is used as a fluorine-contained chemical compound, then the reaction written as SO₂F₂ + OH⁻ → HSO₃F + F⁻ occurs thereby producing fluorine and fluorosulfuric acid (HSO₃F). A liquid mixture of strong acid and an oxidant shows a acidic property so that the OH⁻ ion concentration is low. The above-described reaction is unlikely to take place. The etch rate becomes stable as compared with a cleaning solution where HSO₃F is used.

It is preferable for the foregoing cleaning solution to contain a fluorine-contained chemical compound at such an amount that a semiconductor substrate surface is etched at an etch rate of 0.5-2 nm/min.

Accordingly, residues left on the semiconductor substrate surface are removed without fail.

It is preferable that the foregoing strong acid is sulfuric acid. It is preferable that the foregoing oxidant is hydrogen peroxide.

It is preferable for the foregoing cleaning solution to have a temperature between 80 and 130 °C. If the cleaning solution temperature exceeds 80 °C, this removes residual substances without fail. If below 130 °C, this prevents ions of fluorine from vaporizing. This contributes to realizing a stable etch rate.

It is preferable for the foregoing cleaning solution to have a content of 0.005-0.05% fluorosulfuric acid for a fluorine-contained chemical compound. This ensures that etching is carried out at an etch rate of 0.5-2 nm/min. As a result of such arrangement, residues and particles can be removed without causing any damage to the surface during the cleaning process.

It is preferable for the foregoing cleaning solution to contain enough water to prevent fluorine ions from vaporizing. The etch rate becomes stable as a result and residual substances and particles can be cleared without fail.

The present invention discloses equipment for cleaning a semiconductor device. This semiconductor device cleaning equipment comprises:
(a) a cleaning bath for accommodating a semiconductor substrate,
(b) an oxidant feeder for feeding to the cleaning bath a strong acid and an oxidant to remove organic and inorganic residues from a surface of the semiconductor substrate, and
(c) a fluorine-contained chemical compound feeder for feeding to the cleaning bath a fluorine-contained chemical compound of HSO₃F or SO₂F₂ for generation of fluorine.

It is preferable for the foregoing semiconductor device cleaning equipment to further include:
(a) a detector for detecting the concentration of fluorine in the cleaning bath, and
(c) a controller for controlling the fluorine-contained chemical compound feeder in such a way that the amount of the fluorine-contained chemical compound fed from the fluorine-contained chemical compound feeder is controlled so as to keep the fluorine concentration in the cleaning bath at a constant value.

As a result of such an arrangement, the etch rate becomes stable and residues and particles can be removed in a stable manner.

Instead of employing the foregoing detector and controller, the foregoing semiconductor device cleaning equipment may have another controller for controlling the fluorine-contained chemical compound feeder in such a way that the fluorine-contained chemical compound feeder periodically feeds the fluorine-contained chemical compound just by a predefined amount.

As a result of such an arrangement, the fluorine concentration is kept at an approximately constant value. The etch rate becomes stable. Residues and particles can be removed in a stable manner.

### BRIEF DESCRIPTION OF THE DRAWINGS

FIGURE 1 shows first semiconductor device cleaning equipment according to the present invention.

FIGURE 2 shows second semiconductor device cleaning equipment according to the present invention.

FIGURE 3 compares the etch rate time-variation of silicon dioxide (SiO₂) by adding hydrofluoric acid to a liquid mixture of sulfuric acid and hydrogen peroxide with the etch rate time-variation of SiO₂ by adding HSO₃F to the same liquid mixture.

FIGURE 4 shows the fluorosulfuric acid concentration/the hydrofluoric acid concentration versus the SiO₂ etch rate.

FIGURE 5 shows the cleaning solution temperature versus the etch rate.

FIGURES 6a, 6b, and 6c show oxide breakdown fields of semiconductor devices having MOS capacitors, FIGURE 6a showing a breakdown field for a cleaning solution according to the present invention, FIGURE 6b showing a breakdown field for a conventional cleaning solution, and FIGURE 6c showing a breakdown filed for another conventional cleaning solution.

FIGURES 7a and 7b respectively show residue removal states, FIGURE 7a depicting a semiconductor substrate surface that has been washed using a cleaning solution of sulfuric acid and hydrogen peroxide and FIGURE 7b depicting a semiconductor substrate surface that has been washed using a cleaning solution according to the present invention.

FIGURE 8 roughly shows conventional semiconductor device cleaning equipment.

### DETAILED DESCRIPTION OF THE INVENTION

A first preferred embodiment of the present invention is now described by reference to the accompanying drawings.

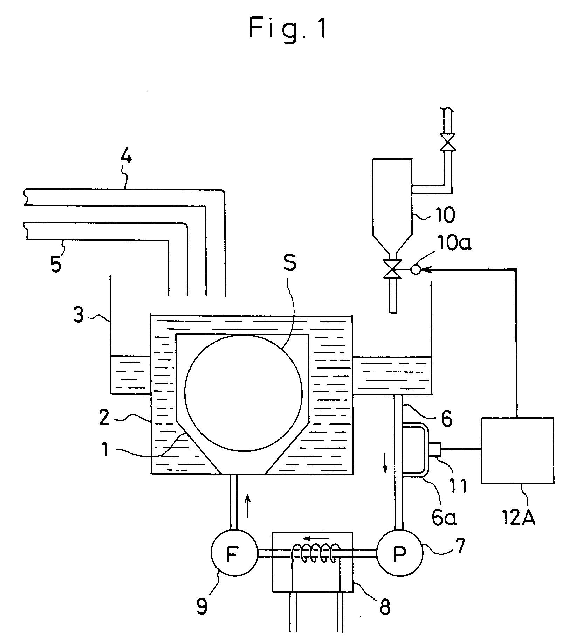

FIGURE 1 shows equipment for cleaning semiconductor devices according to the present invention.

FIGURE 1 shows a carrier 1 for holding a semiconductor substrate S and a cleaning bath 2 of Teflon (registered trademark) that holds a cleaning solution. In the cleaning bath 2, the semiconductor substrate S is washed. An outer bath 3 is so arranged that it catches the overflow from the cleaning bath 2 for circulation of the caught cleaning solution. FIGURE 1 further shows a strong acid feed pipe 4 that conducts a strong acid such as sulfuric acid, an oxidant feed pipe 5 that conducts an oxidant such as hydrogen peroxide, and a cleaning solution circulation pipe 6 that returns the overflow from the cleaning bath 2 to the outer bath 3 to the cleaning bath 2. The cleaning solution circulation pipe 6 has a pump 7 for forcing the cleaning solution to a next station, a heater 8 for heating the cleaning solution, and a filter 9 for filtering the cleaning solution. FIGURE 1 still further shows a fluorosulfuric acid feeder 10 for feeding HSO₃F into the outer bath 3, a fluorine concentration detector 11 attached to a bypass 6a of the cleaning solution circular pipe 6, and a controller 12A for controlling a flow passage open-close valve 10a of the fluorosulfuric acid feeder 10 depending on the output signal of the fluorine concentration detector 11.

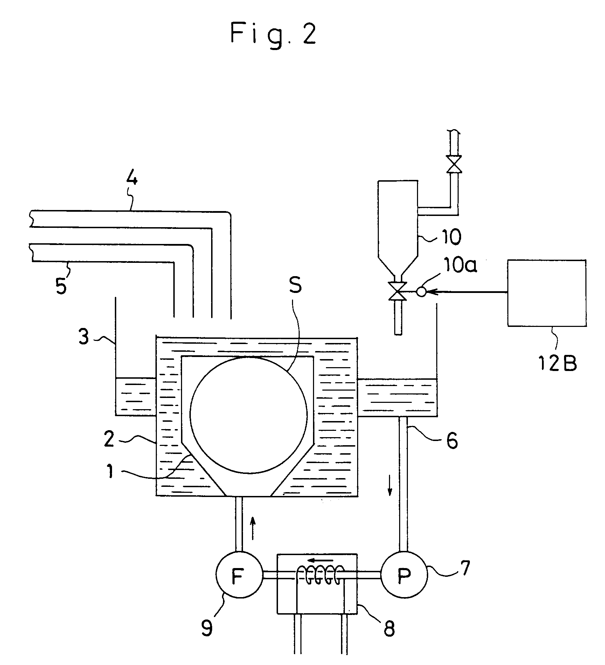

FIGURE 2 shows second semiconductor device cleaning equipment according to the present invention. The same reference numerals are used for like elements.

Instead of using the fluorine concentration detector 11 and the controller 12A of the first semiconductor device cleaning equipment, the second semiconductor device cleaning equipment employs a controller 12B for controlling the flow passage open-close valve 10a, whereby the flow passage open-close valve 10a periodically opens for a certain period of time.

In the first and second semiconductor device cleaning equipment, a single cleaning bath 2 is provided. A plurality of cleaning baths 2 may be provided with consideration of throughput.

Teflon (registered trademark) is a preferable material for the cleaning bath 2. Other materials may be useful (e.g., quartz and material obtained by subjecting ceramic materials including alumina and boron nitride to a sintering process and by coating the surface with teflon) in order to adequately control the cleaning solution concentration and the etch rate.

A semiconductor device cleaning technique by the second semiconductor device cleaning equipment is now described.

In the first place, a given amount of strong acid such as sulfuric acid and a given amount of oxidant such as hydrogen peroxide are fed into the cleaning bath 2 through the strong acid feed pipe 4 and the oxidant feed pipe 5, thereby letting the cleaning bath 2 overflow. The overflow from the cleaning bath 2 is caught by the outer bath 3. A hydrogen peroxide having a concentration of 30% is used. Next, the fluorosulfuric acid feeder 10 feeds a given amount of HSO₃F to the outer bath 3. This HSO₃F and the overflow from the cleaning bath 2 are mixed together in the outer bath 3. The mixed cleaning solution is heated by the heater 8 of the cleaning solution circulation pipe 6 up to, say, 100 °C, thereafter being forwarded by the pump 7 to the cleaning bath 2 through the filter 9.

Next, a conveyor robot (not shown) conveys the carrier 1 holding the semiconductor substrate S into the cleaning bath 2 in which the semiconductor substrate S is washed.

Upon completion of the cleaning of the semiconductor substrate S, the conveyor robot conveys the carrier 1 into a water-washing bath (not shown) in which the semiconductor substrate S is subjected to a QDR rinse so as to rinse the lingering cleaning solution out of the semiconductor substrate's S surface. Thereafter, the semiconductor substrate S is dried by, for example, a spin dryer (not shown).

A preferable cleaning solution may be prepared by adding 0.005-0.05% fluorosulfuric acid (HSO₃F) to a mixture with a 5 : 1 ratio of sulfuric acid : hydrogen peroxide.

As a result of such arrangement, the sulfuric acid-hydrogen peroxide liquid mixture gets rid of organic and inorganic residues from the semiconductor substrate S. Fluorine ions are formed by the reaction as follows:

HSO₃F + H₂O → ←H₂SO₄ + HF (1).

The fluorine ions thus formed lift particles off the surface of the semiconductor substrate S. Like sulfuric acid, HSO₃F is a strong acid thereby contributing to the removal of organic residues.

As expressed by the chemical equation (1), a state of equilibrium is maintained. Therefore, if fluorine ions vapor, then the foregoing reaction proceeds rightwards leading to automatic production of hydrofluoric acid and fluorine ions. If the fluorine ion concentration increases due to the vaporization of water, then the reaction proceeds leftwards. Therefore, FSO₃H is generated while the amount of fluorine decreases thereby lowering the fluorine ion concentration. In this way, the amount of fluorine ion is kept at an approximately constant value, and stable etching to a silicon dioxide layer becomes possible. No residues nor particles are left on the semiconductor substrate surface.

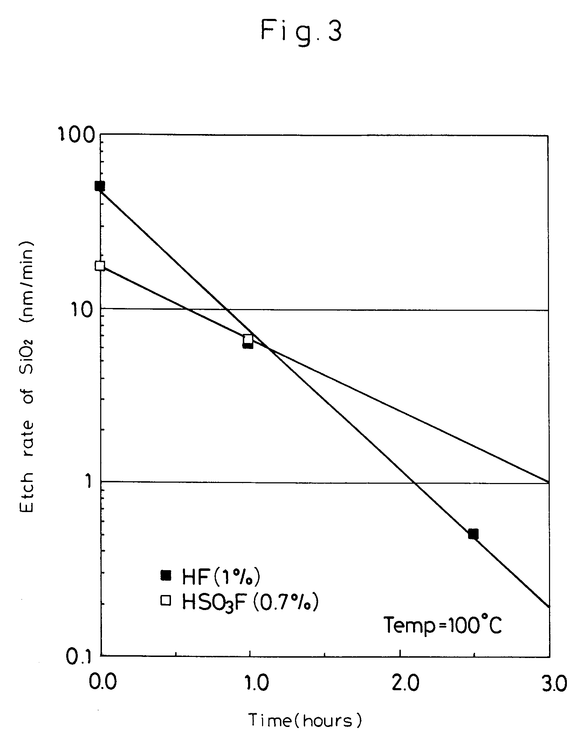

FIGURE 3 is a graph showing the etch rate time-variation of SiO₂ for a solution formed by adding 1% hydrofluoric acid to a liquid mixture with a 5 : 1 ratio of sulfuric acid : hydrogen peroxide and the etch rate time-variation of SiO₂ for another solution formed by adding 0.7% fluorosulfuric acid to the same liquid mixture. The temperature of both of the cleaning solutions is about 100 °C. Correct etch rate comparison cannot be made at a 0 time elapsed point because one of these two different solutions contains 1% hydrofluoric acid and the other contains 0.7% fluorosulfuric acid. The etch rate by the solution having 0.7% fluorosulfuric acid does not time-vary very much, compared with the etch rate by the solution having 1% hydrofluoric acid (see FIGURE 3).

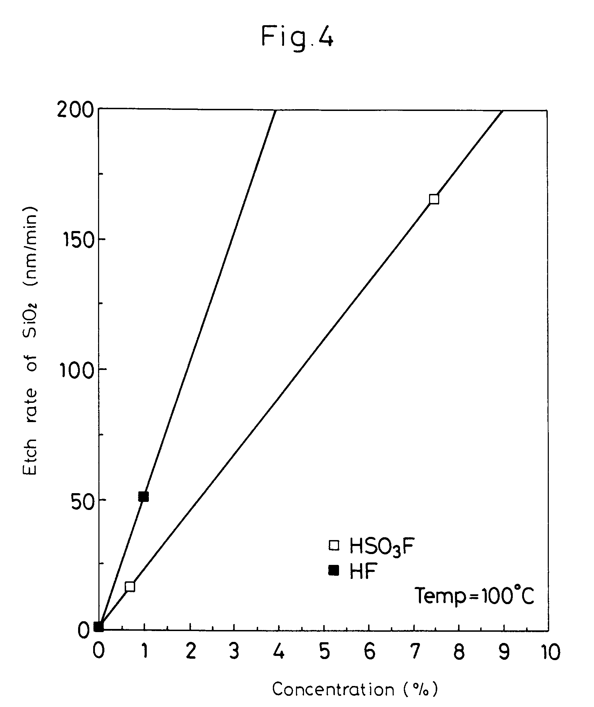

FIGURE 4 shows the fluorosulfuric acid concentration/the hydrofluoric acid concentration versus the SiO₂ etch rate. The temperature of both of the cleaning solutions is about 100 °C.

In order to remove residues and particles from a semiconductor substrate surface, it is preferable for the semiconductor substrate surface to be etched several nanometers. Usually, the process of cleaning takes 5 to 10 minutes. Preferably, the etch rate lies within the 0.5-2 nm/min range. To obtain this etch rate, the fluorosulfuric acid concentration should be within the 0.005-0.05% concentration range.

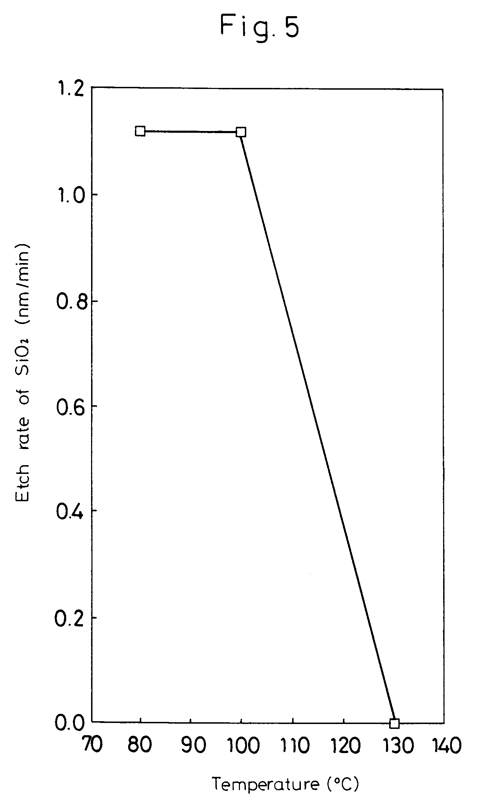

FIGURE 5 shows the cleaning solution temperature versus the etch rate. It is preferable that the cleaning solution temperature is between 80 and 130 °C, the reasons for which are as follows. If the cleaning solution temperature is below 80 °C, then this causes a drop in the capability of lifting off photoresists as well as in the capability of decomposing organic matter. This results in the serious decrease in throughput. If the cleaning solution temperature exceeds 130 °C, this boosts the vaporization of fluorine ions so that little etching by fluorine ions takes place. Where the cleaning solution temperature is 80-100 °C, the vaporization of fluorine ions is suppressed and the supply of hydrofluoric acid and fluorine ions is made because of the reaction expressed by the chemical equation

### (1). The etch rate becomes very stable.

The amount of water being included is now considered.

The etch rate time-variation of SiO₂ by a cleaning solution formed by adding 0.7% fluorosulfuric acid to sulfuric acid having a concentration of 89% is greater than the etch rate time-variation of SiO₂ by another cleaning solution formed by adding 0.7% fluorosulfuric acid to a mixture of sulfuric acid and hydrogen peroxide. In other words, the former cleaning solution has poor stability.

A cleaning solution, formed by adding 7.5% fluorosulfuric acid to a liquid mixture of sulfuric acid and hydrogen peroxide, was examined. The examination showed that the etch rate time-variation in the case of this cleaning solution was great, compared with the foregoing cleaning solution having a content of 0.7% fluorosulfuric acid. Ions of fluorine stably etch SiO₂ when there exists enough water for hydrogen bonding with the water in the cleaning solution. In a cleaning solution having a large content of concentrated sulfuric acid or fluorosulfuric acid having a large capacity for moisture absorption, water is absorbed into the concentrated sulfuric acid. As a result, no etching by fluorine ions takes place. Hydrogen fluoride, which gives hydrofluoric acid with water, is a gas with a boiling point of 20 °C so that it can exist only in the form of a water solution at a temperature of 100 °C. The etch rate time-varies very much when there does not exist much water.

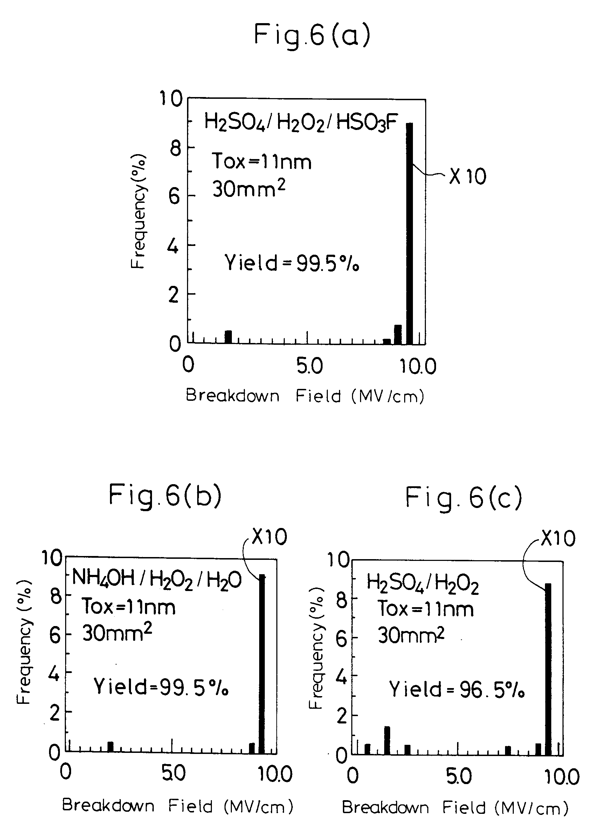

FIGURES 6a, 6b, and 6c show oxide breakdown fields of semiconductor devices having MOS capacitors each of which comprises a LOCOS isolation layer, a n⁺ polysilicon electrode, and a gate oxide layer having a thickness of about 11 nm. The process of cleaning is performed before forming a gate oxide layer. FIGURES 6a, 6b, and 6c show the cleaning performance of (A) a cleaning solution of the present embodiment, (B) a cleaning solution including ammonium hydroxide and hydrogen peroxide, and (C) a cleaning solution including sulfuric acid and hydrogen peroxide. As seen from these figures, the cleaning solution (A) of the invention is identical in yield with the cleaning solution (B) and is superior to the cleaning solution (C). To sum up, the present cleaning solution has the same capability of removing particles as the cleaning solution (B) does.

FIGURES 7a and 7b show in cross section residue removal states after a polysilicon layer has been dry-etched through a resist pattern, FIGURE 7a depicting a semiconductor substrate surface that has been washed using a cleaning solution that contains sulfuric acid and hydrogen peroxide and FIGURE 7b depicting a semiconductor substrate surface that has been washed using a cleaning solution according to the present invention. As shown in FIGURE 7a, the semiconductor substrate surface washed with the former cleaning solution still carries an etching residue. Conversely, as shown in FIGURE 7b, the semiconductor substrate surface washed by the cleaning solution according to the invention now carries no residues after dry etching.

The fluorine concentration detector 11 and the controller 12A, shown in FIGURE 1, are described.

The fluorine concentration detector 11 measures infrared ray absorption due to, for example, H-F bonding or UV absorption so as to detect the concentration of fluorine in the cleaning solution passing through the cleaning solution circulation pipe 6, thereby sending out a fluorine concentration signal to the controller 12A. The controller 12A opens the flow passage open-close valve 10a of the fluorosulfuric acid feeder 10 just for a given period of time if the fluorine concentration is below a predefined value. In this way, the concentration of the fluorine of the cleaning solution is kept approximately constant.

The controller 12B of FIGURE 2 is described. The rate of the fluorine concentration drop with time is found beforehand. The controller 12B controls the flow passage open-close valve 10a of the fluorosulfuric acid feeder 10 so that the valve 10a periodically opens just for a given period of time. Alternatively, fluorosulfuric acid (HSO₃F) is allowed by a metering pump to drop from the fluorosulfuric acid feeder 10 at specific intervals of time. This control technique is detailed by reference to the following equation:

v = VC {1 - exp (- Aexp [- Ea/RT] × t}/(Ci - C) (2)

where T is the processing temperature, t is the elapsed time, v is the amount of HSO₃F added, V is the cleaning solution total volume, Ci is the original HSO₃F concentration, A is the constant, C is the amount of HSO₃F in the cleaning solution, R is the gas constant, and Ea is the activation energy.

The examination of the present embodiment showed that the etch rate change (i.e., the fluorine concentration time-variation) was approximated with a first-order reaction. The activation energy Ea was found to be 30.7 kJ/mol. If the constant A is derived from cleaning equipment which actually performs the process of cleaning, the volume of HSO₃F being added can be found. For example, in a case where the concentration of HSO₃F is set at a concentration of 0.01% and HSO₃F is added for every one hour, C = 0.01 and t = 60 are substituted in the foregoing equation. With the help of a timing device that provides a time signal for every one hour, HSO₃F is fed just by a precalculated amount. A microcomputer may be used so as to additionally feed a given amount of HSO₃F at specific intervals of time.

The foregoing approximation equation eliminates the need for the provision of the fluorosulfuric concentration detector 11 thereby maintaining the effect of cleaning at low costs.

Instead of using HSO₃F, SO₂F₂ may be included into a liquid mixture of sulfuric acid and hydrogen peroxide. In this case, SO₂F₂ reacts with OH⁻ of the liquid mixture to produce fluorine and HSO₃F, which is written as follows:

SO₂F₂ + OH⁻ → HSO₃F + F⁻ (3).

Such a liquid mixture shows an acidic property so that the OH⁻ ion concentration is low. The above-described reaction is unlikely to take place. The etch rate becomes stable as compared with a cleaning solution where HSO₃F is added to a sulfuric acid-hydrogen peroxide liquid mixture.

## Claims

1. A method of cleaning a semiconductor device wherein a cleaning solution is used to wash a surface of a semiconductor substrate, said cleaning solution having a composition of:
(a) a strong acid and an oxidant to remove organic and inorganic residues from said surface of said semiconductor substrate,
(b) a fluorine-contained chemical compound of HSO₃F or SO₂F₂ which generates fluorine to remove other residues and particles from said surface of said semiconductor substrate by slightly etching said surface of said semiconductor substrate, and
(c) water.

2. The semiconductor device cleaning method as in claim 1, wherein said cleaning solution contains said fluorine-contained chemical compound at such an amount that said surface of said semiconductor substrate is etched at an etch rate of 0.5-2 nm/min.

3. The semiconductor device cleaning method as in claim 1, wherein said strong acid is sulfuric acid.

4. The semiconductor device cleaning method as in claim 1, wherein said oxidant is hydrogen peroxide.

5. The semiconductor device cleaning method as in claim 1, wherein said cleaning solution has a temperature between 80 and 130 °C.

6. The semiconductor device cleaning method as in claim 1, wherein said cleaning solution has a content of 0.005-0.05% fluorosulfuric acid (HSO₃F) for said fluorine-contained chemical compound.

7. The semiconductor device cleaning method as in claim 1, wherein said cleaning solution contains enough water to prevent fluorine ions of said cleaning solution from vaporizing.

8. Equipment for cleaning a semiconductor device comprising:
(a) a cleaning bath for accommodating a semiconductor substrate,
(b) an oxidant feeder for feeding to said cleaning bath a strong acid and an oxidant to remove organic and inorganic residues from a surface of said semiconductor substrate, and
(c) a fluorine-contained chemical compound feeder for feeding to said cleaning bath a fluorine-contained chemical compound of HSO₃F or SO₂F₂ for generation of fluorine.

9. The semiconductor device cleaning equipment as in claim 8 further comprising:
(a) a detector for detecting the concentration of the existing fluorine in said cleaning bath, and
(c) a controller for controlling said fluorine-contained chemical compound feeder in such a way that the amount of said fluorine-contained chemical compound fed from said fluorine-contained chemical compound feeder is controlled so as to keep the fluorine concentration in said cleaning bath at a constant value.

10. The semiconductor device cleaning equipment as in claim 8, further comprising a controller for controlling said fluorine-contained chemical compound feeder in such a way that said fluorine-contained chemical compound feeder periodically feeds said fluorine-contained chemical compound by a predefined amount.
